Europäisches Patentamt

European Patent Office

Office européen des brevets

(19)

(11) Publication number: **0 169 519 B1**

(12)

# EUROPEAN PATENT SPECIFICATION

(45) Date of publication of patent specification: **25.09.91**   (51) Int. Cl.⁵: **H01L 21/82**, H01L 27/16, H01L 21/306, //G01F1/68

(21) Application number: **85109095.1**

(22) Date of filing: **20.07.85**

(54) Semiconductor device and method for its fabrication.

(30) Priority: **25.07.84 US 634087**

(43) Date of publication of application:
**29.01.86 Bulletin 86/05**

(45) Publication of the grant of the patent:
**25.09.91 Bulletin 91/39**

(84) Designated Contracting States:
**DE FR GB NL**

(56) References cited:
**EP-A- 0 134 859**

**JOURNAL OF THE ELECTROCHEMICAL SOCI-
ETY, vol. 125, no. 8, August 1978, pages
1321-1327, New York, US; E. BASSOUS et al.:
"The fabrication of high precision nozzles
by the anisotropic etching of (100) silicon"**

(73) Proprietor: **HONEYWELL INC.**
**Honeywell Plaza**
**Minneapolis Minnesota 55408(US)**

(72) Inventor: **Bohrer, Philip J.**
**2604 West 55th Street**
**Minneapolis Minnesota 55410(US)**
Inventor: **Higashi, Robert E.**
**10000 Nicollet Avenue South Apartment 212**
**Bloomington Minnesota 55420(US)**
Inventor: **Johnson, Robert G.**
**12814 March Circle**
**Minnetonka Minnesota 55343(US)**

(74) Representative: **Rentzsch, Heinz et al**
**Honeywell Europe S.A. Holding KG Kaiser-
leistrasse 55 Postfach 184**
**W-6050 Offenbach am Main(DE)**

## Description

The present invention relates to integrated semiconductor device technology in the field of sensors and radiant sources of electromagnetic energy. More specifically, the present invention relates to a method of fabrication and to structures of semiconductor devices of the class as described in prior EP-A 134 859, published 27.3.1985. Such devices have applications in areas including flow sensing, detection of combustible gases, humidity sensing, and pressure sensing. However, neither these devices nor the present invention is limited to such applications.

It is the main object of the present invention to increase the area which can be effectively used on a semiconductor body and to improve the reliability of the electrical connections to such area. This is accomplished by the structure 1 and by the method of manufacturing characterized in the claims.

The present invention comprises a method of fabricating a semiconductor device comprising a thin film member having a predetermined configuration bridging a depression etched into a first surface of a semiconductor body. The member is connected to the first surface at first and second substantially opposing ends of the predetermined configuration. The depression opens to the first surface along an edge on each side of the member. The method comprises the steps of providing a semiconductor body with a first surface having a predetermined orientation with respect to a crystalline structure in the semiconductor body. A layer of thin film material of which the member is comprised is applied onto the first surface. First and second openings are exposed through the thin film material to the first surface. The first opening is bounded in part by one edge of the member. The second opening is bounded in part by the other edge of the member. Both openings are also bounded in part by a boundary connected to an edge of the member. At least one of the boundaries has a predetermined boundary configuration formed so that, when an anisotropic etch is placed on the openings to undercut the member and form the depression, there will be no substantial undercutting of the semiconductor body below the thin film material at the predetermined boundary configuration.

The present invention further comprises an integrated semiconductor device comprising a semiconductor body with a first surface having a predetermined orientation with respect to a crystalline structure in the semiconductor body. The semiconductor body has a depression formed into the first surface of the body. A layer of thin film material covers at least a portion of the first surface. A thin film member comprising the layer of material has a predetermined configuration bridging the depression. The member is connected to the first surface at substantially opposing ends of the predetermined configuration. The depression opens to the first surface along an edge on each side of the member. The layer of thin film material comprises first and second openings, the first opening being bounded in part by one edge of the member, the second opening being bounded in part by the other edge of the member. Both openings are also bounded in part by a boundary connected to an edge of the member. At least one of the boundaries has a predetermined boundary configuration formed so that, when an anisotropic etch is placed on the openings to undercut the member and form the depression, there will be no substantial undercutting of the semiconductor body below the thin film material at the predetermined boundary configuration, which is in contrast to the device disclosed in EP-A-0134 859.

Substantially eliminating undercutting of the semiconductor body below the thin film material at the predetermined boundary configuration substantially eliminates overhang of the thin film material at these locations. Substantially avoiding such overhang is frequently important since such overhang is frequently wasted space on a semiconductor chip. Such area is unavailable for diodes on other electronic structures in the semiconductor body. Further, because of breakage possibilities in handling and processing, thin film conductors such as gold conductors on the order of 0.3-0.5 $\mu$m thick cannot be wisely placed there because they add stress to the overhang, which, if it fractures, will cause an open circuit as well as possible mechanical and thermal interference if a fragment is lodged, for example, under the bridged structures of the present invention. In addition, making the openings without substantial overhang facilitates air flow and/or thermal isolation of the bridged member from the semiconductor body. Accordingly, devices in accordance with the present invention avoid wasted space on semiconductor chips, enhance thermal isolation of elements on the bridged member, and result in small, less costly and more reliable chips and devices. For describing an embodiment of the invention with reference to the drawings:

Figures 1-5 illustrate a preferred embodiment of a flow sensor, and

Figure 6 illustrates circuitry for operating the disclosed sensor.

Although structures in accordance with the present invention have many applications as indicated above, the present invention will be disclosed in part using an example of a preferred embodiment of a flow sensor compatible with the present invention. As previously indicated, however, the present invention is not limited to flow sensors.

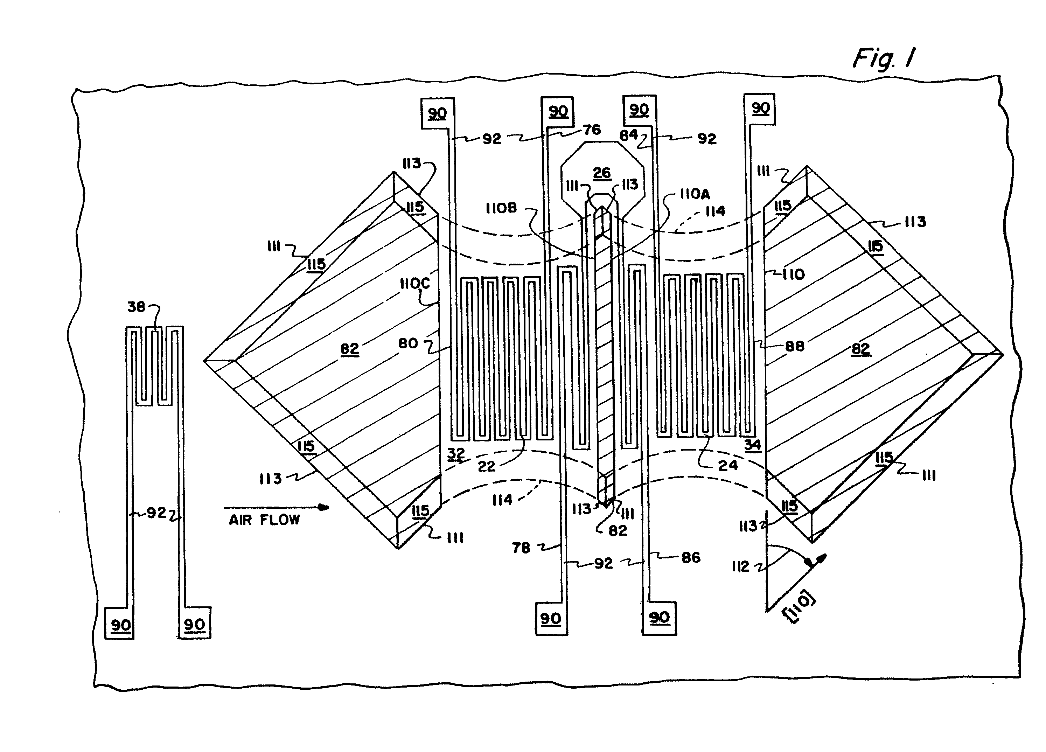

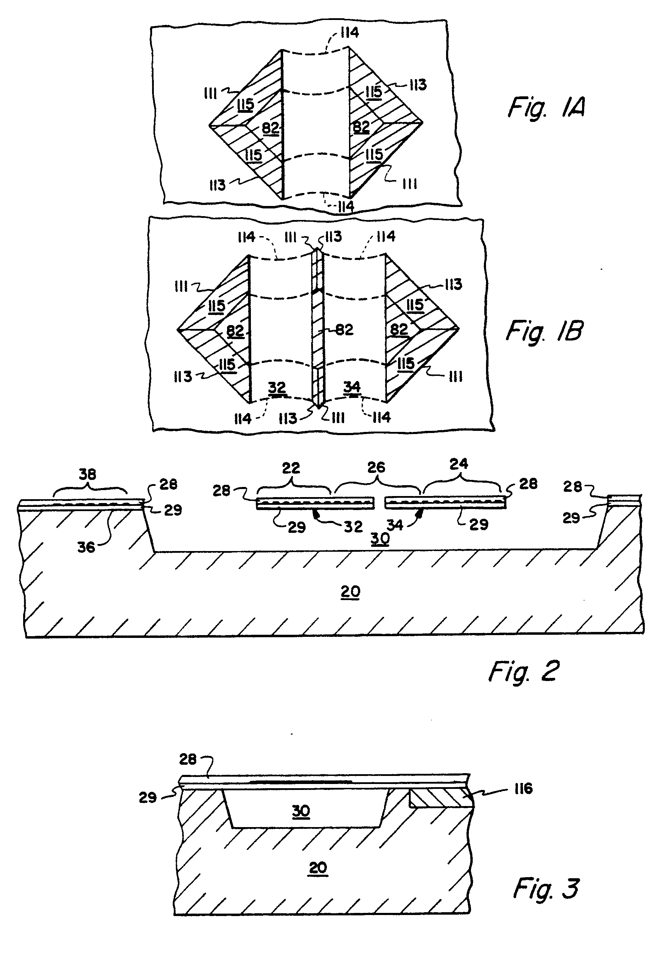

Devices in accordance with the present invention can have a single bridged member such as illustrated in Figure 1A or a plurality of bridged members such as 32 and 34 illustrated in Figure 1B and in Figures 1-5. Structures in accordance with the present invention typically comprise static electric, thermal-to-electric, and/or electric-to-thermal elements, usually in thin film form, as part of the bridged members. Such structures have many applications, including those listed above.

The present invention comprises a method of fabricating a semiconductor device comprising a thin film member such as 32 or 34 having a predetermined configuration bridging a depression such as 30 etched into a first surface 36 of a semiconductor body 20. A member such as 32 or 34 is connected to first surface 36 at first and second substantially opposing ends of the predetermined configuration. Depression 30 opens to first surface 36 along an edge on each side of the member, e.g., edges such as 110 or 110A (member 34) or such as 110B or 110C (member 32).

The method comprises the steps of providing a semiconductor body such as 20 with a first surface 36 having a predetermined orientation with respect to a crystalline structure in the semiconductor body. A layer such as 28 or 29 of thin film material of which a member is comprised is applied to first surface 36. First and second openings such as 82 are exposed through the thin film material to first surface 36.

The first opening is bounded in part by one edge of a member (e.g., edge 110) the second opening being bounded in part by the other edge of the member (e.g., edge 110A). Both openings are also bounded in part by a boundary connected to an edge of the member. At least one of the boundaries has a predetermined boundary configuration formed so that, when an anisotropic etch is placed on openings such as 82 to undercut members such as 32 or 34 and form a depression such as 30, there will be no substantial undercutting of the semiconductor body below the thin film material at the predetermined boundary configuration.

Such a method results in a structure without substantial overhang of thin film materials such as 28 or 29 at the predetermined boundary configuration, and this is of advantage in many situations as previously indicated.

A preferred method of fabricating the present invention includes providing a semiconductor body comprising (100) silicon having a (100) plane, a [110] direction, and a first surface such as 36 substantially parallel to the (100) plane. A layer of thin film material such as layers 28 and 29 of which members such as 32 or 34 are comprised is applied to first surface 36.

First and second openings such as 82 are exposed through the thin film material to first surface 36. Openings such as 82 are defined so that members such as 32 or 34 are oriented at a nonzero angle to the [110] direction. The first opening such as 82 is bounded in part by one edge of a member (e.g., edge 110 of member 34), and the second opening such as 82 is bounded in part by the other edge of the member (e.g., edge 110A of member 34). Both openings such as 82 are also bounded in part by a boundary connected to an edge of the member. At least one of the boundaries has boundary components such as 111 substantially in line with the [110] direction or boundary components such as 113 substantially normal to the [110] direction.

An anisotropic etch is applied to the exposed surface areas 82 to undercut the member and create a depression 30 under the member.

Using such a preferred procedure, there will be no substantial overhang of thin film materials such as 28 or 29 along the boundary components 111 and 113 substantially in line with or normal to the [110] direction.

The preferred embodiment of a flow sensor comprising the present invention includes a pair of thin film heat sensors 22 and 24, a thin film heater 26, and a base 20 supporting the sensors and heater out of contact with the base. Sensors 22 and 24 are disposed on opposite sides of heater 26.

Body 20 is preferably a semiconductor body and preferrably silicon, chosen because of its adaptability to precision etching techniques and ease of electronic chip producibility. The sensor preferably includes two identical temperature sensing resistor grids 22 and 24 acting as the thin film heat sensors and further includes a centrally located heater resistor grid 26 acting as the thin film heater. Sensors 22 and 24 and heater 26 are preferrably fabricated of nickel-iron, herein sometimes referred to as permalloy, having a preferred composition of 80% nickel and 20% iron. The sensor and heater grids are encapsulated in a thin film of dielectric, typically comprising layers 28 and 29 and preferrably silicon nitride, to form thin film members. In the embodiment shown in Figure 1, the sensor comprises two thin film members 32 and 34, member 32 comprising sensor 22 and member 34 comprising sensor 24, each member comprising one-half of heater 26.

The preferred embodiment the disclosed sensor further comprises an accurately defined air space which results in an air space effectively surrounding elements 22, 24, and 26. The effectively surrounding air space is achieved by fabricating the structure on silicon surface 36, thin film elements 22, 24, and 26 preferrably being encapsulated in thin film silicon nitride film, and by subsequently etching an accurately defined air space into silicon body 20 beneath members 32 and 34.

The operation of the present sensor in sensing air flow can be described with reference to Figure 1. Heater resistor grid 26 operates at a preferred constant average temperature difference of 100-200 °C elevated above the temperature of silicon chip 20 which temperature is not appreciably different from the ambient air stream temperature. The power required by heater resistor 26 to achieve 200 °C above ambient temperature is very small, being on the order of 0.010 watt.

In the preferred embodiment at zero airflow velocity, thermal conduction from heater resistor grid 26, largely through surrounding air space including air space 30, heats identical temperature sensing resistor grids 22 and 24 to an average temperature of about 60-70% of the temperature elevation of heater element 26. In the preferred embodiment illustrated, sensor grids 22 and 24 are precisely symmetrically located with respect to heater grid 26 so that at zero airflow they have identical temperatures and have no differences between their resistances. Consequently, a small probe current, 0.1-1.0 milli-amperes preferred, through both sensor resistances 22 and 24 will develop no voltage difference at zero airflow velocity.

With airflow present, upstream resistors sensor 22 will be cooled by the transportation of heat away from sensor 22 toward heater resistor grid 26, whereas downstream sensor 24 will be heated by a transportation of heat toward the sensor from heat resistor grid 26. Consequently, a resistance difference between sensor resistances 22 and 24 will be present with a corresponding difference in voltage drop which is a measure of the air flow. Typical unamplified voltage differences can be as high as 0.1 volt at a 7,62 m/sec flow velocity.

In the preferred operation of the present sensor, sensors 22 and 24 are operated with constant current such that temperature field changes can be sensed under flow conditions as previously described. Other operating arrangements are also possible.

Because of the exceedingly small thermal mass of the heater and sensor element structure and the thermal insulation provided by the thin silicon nitride connecting means to the supporting silicon body, and because of the surrounding air space, response time of the present sensor is very short, with response time constants of 0.005 seconds having been measured. Consequently, sensor elements 22 and 24 can respond very rapidly to air flow changes.

In the preferred embodiment of the present sensor, ambient temperature is monitored by a reference resistor 38 which is heat sunk onto semiconductor body 20. Resistor 38 may be a permalloy grid formed substantially like grids 22, 24 and 26 and is typically encapsulated in dielectric layers 28 and 29 and mounted on surface 36.

The typical 0.8 $\mu$m total thickness of dielectric layers 28 and 29 is very thin and, accordingly, permits relatively good heat conduction and transfer perpendicular to the layers to and from resistive grids 22, 24, 26 and 38. Thus, reference resistor 38, being attached by the encapsulating dielectric directly to surface 36 of semiconductor body 20, readily monitors the temperature of the semiconductor body, which stays within 0.5 degrees centigrade of ambient temperature even with resistor grid 26 elevated to 200 degrees centigrade above ambient. Accordingly, heat sunk reference resistor 38 may be used to monitor ambient air flow temperature by monitoring a temperature that is very close to that of semiconductor body 20, which in turn is very close to ambient temperature.

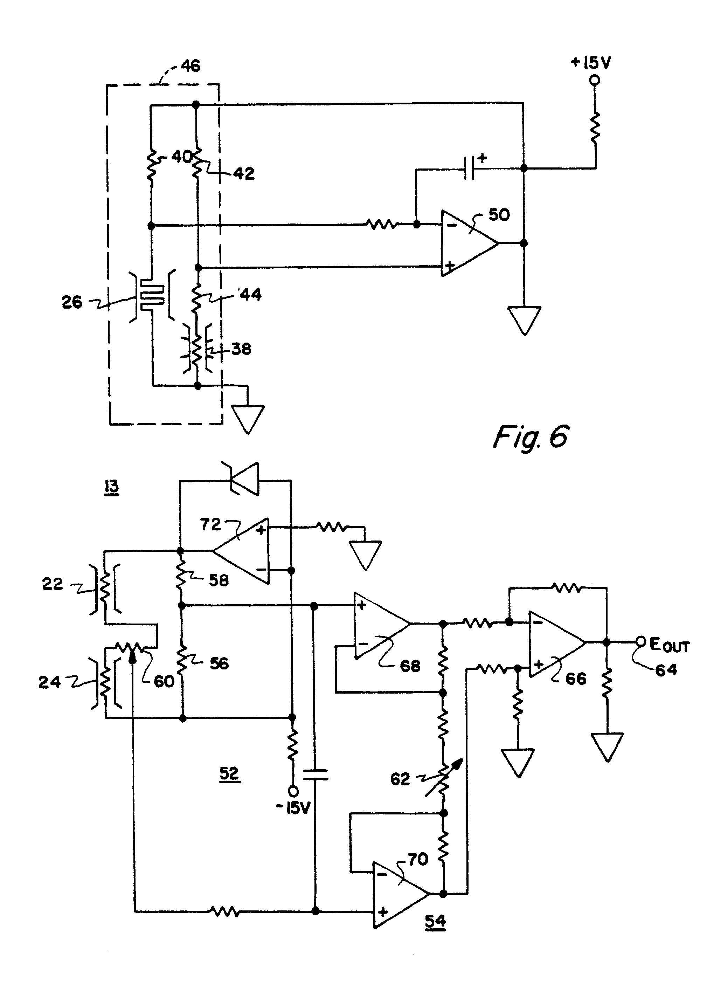

As previously indicated in the preferred operation of the present sensor, heater 26 is operated at a constant temperature above ambient temperature, sensors 22 and 24 being operated at constant current, and the changing temperatures of sensors 22 and 24 are sensed as changes in resistance. Circuits for accomplishing these functions are illustrated in Figure 6. The smaller circuit controls the temperature of heater 26 while the larger circuit provides an output voltage that is proportional to the resistance difference between heat sensing resistors 22 and 24.

The heater control circuit illustrated in Figure 6 uses a Wheatstone bridge 46 to maintain heater 26 at a constant temperature rise above ambient as sensed by heat sunk reference resistor 38. Wheatstone bridge 46 is shown comprising heater resistor 26 and a resistor 40 in its first leg and a resistor 42, heat sunk resistor 38 and a resistor 44 in its second leg. An error integrator comprising amplifier 50 keeps bridge 46 balanced by varying the potential across it and thus the power dissipated in heater 26.

The circuity which monitors the resistance difference between downstream sensor 24 and upstream sensor 22 includes a constant current source 52 comprising an amplifier 72 and a differential amplifier 54 comprising amplifier 68 and 70. The constant current source drives a Wheatstone bridge comprising two high impedance resistors 56 and 58 in one leg and the two sensing resistors 22 and 24 with a nulling potentiometer 60 in the other leg. The gain of differential amplifier 54 is adjusted by potentiometer 62. Output 64 provides a voltage that is proportional to the resistance difference between the two sensing resistors 22 and 24.

Amplifiers 50, 66 and 72 may each comprise one-fourth of an LM324. Amplifiers 68 and 70 may each comprise one-half of an OP-10. In Fig. 1 upstream sensor resistor 22 preferrably has an inner edge 76 in close proximity (5 to 10 μm, for example) to the near edge 78 of heater resistor grid 26. At such a separation from near edge 78 of heater resistor grid 26, the zero flow air temperature near heater resistor edge 78 is close to that of edge 78. In a typical embodiment, where sensors 22 and 24 have a width of approximately 100 μm, outer edge 80 of sensor resistor grid 22 is located approximately 100 μm from near edge 78 of heater resistor grid 26. At the 100 μm separation, the zero airflow temperature is closer to that of the ambient air stream and to that of silicon chip 20 than it is to the temperature of heater resistor 26.

Therefore, outer edge 80 of sensor resistor grid 22 is easily cooled to near the limiting temperature of silicon chip 20 by low velocity airflow, whereas the inner regions of sensor resistor grid 22 (near edge 76) are more tightly coupled thermally to heater resistor 26 and respond more readily to the higher airflow velocity before the limiting temperature of the ambient airstream is approached. Accordingly, the composite effect of the temperature change from each resistor grid line (lines spaced over the approximately 5-100 μm distance from heater edge 76) for an increment of airflow is to keep the corresponding increment on the upstream resistor temperature response curve more nearly constant over a broad airflow range.

As shown in Figure 1, areas 82 are cut in the silicon nitride to facilitate etching as further described below. Overall geometry, including that of leads 92, is preferably made symmetrically to insure symmetrical heat conduction properties on members 32 and 34. Leads 92 connect to pad areas 90 for electrically connecting sensor elements 22, 24, 26, and 38 with circuitry 13 as previously discussed.

Elements 22 and 24 have a preferred resistance in one example of 1200 ohms and element 26 has a preferred resistance in that example of 520 ohms. In this embodiment, sensors 22 and 24 have a width of approximately 100 μm and a length of approximately 175 microns. As previously indicated, in this example the proximal edges of sensors 22 and 24 are in close proximity(e.g., 5-10 μm) away from heater 26. That is, edge 76 of sensor 22 is 5-10 μm away from edge 78 of heater 26, and edge 84 of sensor 24 is 5-10 μm away from edge 86 of heater 26.

As with other dimensions listed in the present application, the above dimensions are preferred dimensions which have been used in actual devices and are not deemed to be limiting, since these parameters could be substantially varied depending upon application.

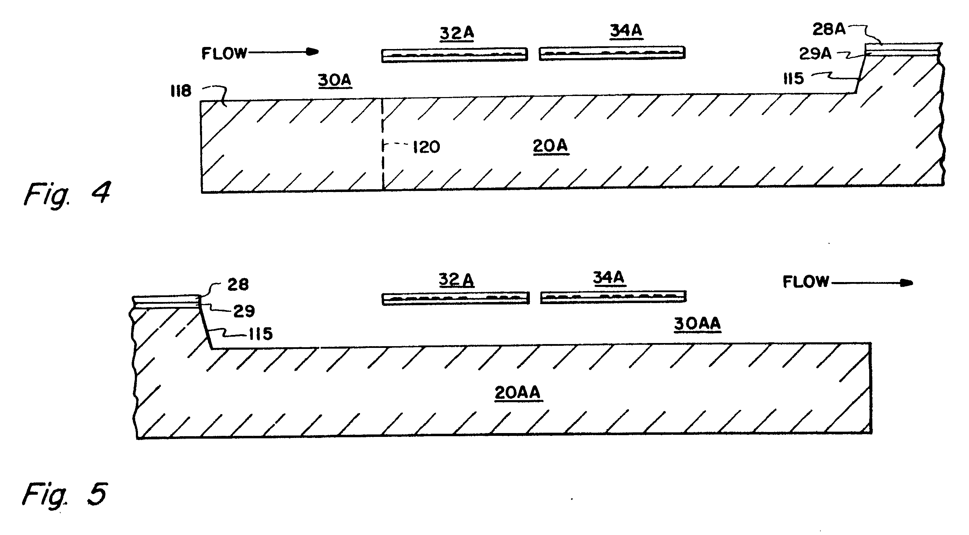

Sensing elements 22 and 24 may be located within the boundaries of a walled depression 30 as illustrated in Figure 2. Alternately, elements 22 and 24 may be located at the edge of a chip or body so that either the upstream portion of a depression 30A is open to receive flow unimpeded by a sidewall, as shown in Figure 4, or open at the downstream side so that flow may more easily exit, or be more easily drawn through, an air space 30AA as illustrated in Figure 5. Note that the embodiment of Figure 4 may be modified by removing at least a portion of the leading edge of body 20A, thus increasing the exposure of the leading edge of member 32A to flow; for example, portion 118 of body 20A may be removed back to line 120.

A part of the preferred process of fabricating the present sensor is disclosed in EP-A-859 0134. The process comprises providing a (100) silicon wafer 20 having a surface 36 which receives a layer 29 of silicon nitride. Layer 29 is typically 400 nm thick and is typically deposited by standard sputtering techniques in a low pressure gas discharge. Next, a uniform layer of permalloy, typically 80% nickel and 20% iron and 80 nm thick, is deposited on the silicon nitride by sputtering.

Using a suitable photo mask, a photoresist and a suitable etchant, permalloy elements such as 22, 24, 26 and 38 are delineated. A second layer 28 of silicon nitride, typically 400 nm thick, is then sputter-deposited to provide complete coverage of the permalloy configuration and thus protect the resistive element from oxidation. Openings 82 are then etched through the nitride to the (100) silicon surface in order to delineate each member such as 32 and 34. The relative sizes of openings 82 are largely a matter of design choice. Dotted lines 114 represent the shape of depressions such as 30 under the ends of members such as 32 and 34.

Finally, anisotropic etchant that does not appreciably attack the silicon nitride is used to etch out the silicon in a controlled manner from beneath members such as 32 and 34. KOH plus Isopropyl alcohol is a suitable etchant . The sloping sides of the etched depression such as 30 are bounded by (111) and other crystal surfaces that are resistive to the etchant. The depression bottom, a (100) surface which is much less resistant to the etchant, is located at a specified distance (e.g., 125 μm) from the members, typically by adjusting the duration of the etch. A doped silicon etch stop (e.g., a boron-doped layer) may also be used to control the depth of the depression, although such stops are not typically necessary when fabricating the present sensor. By adjusting the duration of the etch, the depth of depressions such as 30 can be controlled to a precision of about three μm or to about two percent. This precision results in a precise reproducibility of the thermal conductance of the air space surrounding the members and a correspondingly precise reproducibility of air flow response.

In order to obtain efficient undercutting of cantilever members and in order to undercut bridged members of the type shown in Figure 3, the predetermined configuration of the member, e.g., typically a straight edge such as 110 (Figure 1) or an axis of the member, is oriented at a non-zero angle 112 to the [110] axis of the silicon (while fabricating sensors such as the one disclosed will typically involve placing a straight member edge or an axis at an angle to the [110] silicon axis, it is conceivable that a member could be shaped such that no straight edges are involved or that no axis is easily defined, but that the configuration itself is still oriented to achieve the undercutting or to achieve in a minimum time, as further discussed below).

By making angle 112 substantially 45 degrees, the member will be undercut in a minimum amount of time. Further, using a non-zero orientation permits fabrication of two-ended bridges such as shown in Figure 3. Such members are substantially impossible to make in a single processing step with an anisotropic etch and with the member edges oriented substantially with the [110] direction. This is because an anitropic etch will not appreciably undercut at the inside corners or at the (111) crystal planes exposed along the edges of a member if the edges of the members are oriented with the [110] direction. Further, if an isotropic etch is used to undercut the members, substantially less repeatability and precision is achieved, since such an etch does not discriminate between the various crystal planes.

Making angle 112 a 45 degree angle also permits rapid rounding and smoothing of the semiconductor and support interface with the member (see dashed lines 114 defining the ends of members 32 and 34), thus avoiding a stress connection point that otherwise occurs where two (111) planes intersect below dielectric layer 29.

In addition to making angle 112 substantially 45 degrees, it is preferred in accordance to the present invention that the remaining edges of openings 82, e.g. those edges 111 and 113 not defining the edges of members 32 and 34, be oriented either substantially in line with the [110] direction (edges 111 in Figures 1, 1A, and 1B) or substantially normal to the [110] direction (edges 113 in Figures 1, 1A, and 1B). If openings 82 are defined by the edges of members at a 45 degree angle to the [110] direction (e.g., by edges 110 and 110A for member 34 and by edges 110B and 110C for member 32), by edges 111 in line with the [110] direction, and by edges 113 normal to the [110] direction, there will be no undesirable undercutting below dielectric layer 29; i.e., the only undercutting that will then occur when forming depression 30 is undercutting below member 32 and 34, and depression 30 will be defined in size by openings 82 and the area below member 32 and 34. The slanted walls 115 of depression 30 are then formed by (111) planes, which are a natural etch stop to undercutting. The size of openings 82 is largely a matter of design choice.

Figure 3 shows a region 116 for integration of circuitry, for example, portions of the circuitry illustrated in Figure 6.

For the embodiments shown, typical dimensions of members such as 32 and 34 are 0,127 mm - 0,178 mm wide, 0,25mm- 0,51 mm long, and 0.8 - 1.2 μm thick. Typical permalloy elements such as elements 22, 24, 26 and 38 have a thickness of approximately 80 nm (typically in the range of approximately 80 nm to approximately 160 nm) with a preferred composition of 80% nickel and 20% iron and a resistance value within the range of approximately 200 ohms to approximately 2000 ohms at room temperature, e.g., at approximtely 20-25 °C (at permalloy element temperatures up to approximately 400 °C resistance values increase by a factor of up to approximately 3). Line widths within permalloy grids may be approximately 5 μm with a 5 μm spacing. Depressions such as 30 typically have a 0,125 mm (125 μm) depth spacing between members such as 32 and 34 and the semiconductor body such as 20, but the spacing can easily vary in the range of approximately 0,025 mm to approximately 0,25 mm. A typical thickness of the semiconductor body or substrate such as 20 is 0,203 mm. (As previously indicated, dimensions provided are illustrative only and are not to be taken as limitations.)

Typical operating temperatures of heater elements such as 26 are in the range of approximately 100-200 °C with approximately 160 °C above ambient being the preferred operating temperature. Using the preferred permalloy element, this can be accomplished with only a few milliwatts of input power.

A heater resistance element having a 200-1000 ohm preferred resistance at 25 °C provides the desired power dissipation to achieve the preferred operating temperature at a convenient voltage of a few volts and a convenient current of, for example, 2 to 5 milliamperes.

**Claims**

1. A method of fabricating a semiconductor device comprising a semiconductor body (20), a depression (30) etched into a first surface (36) of said semiconductor body, and at least one thinfilm member (32, 34) bridging said depression between opposing edges thereof, including the steps of:

a) selecting a semiconductor body (20) having a predetermined orientation with respect to a crystalline structure in the semiconductor body;

b) applying a layer (28, 29) of thinfilm material of which which the thinfilm member(s) (32, 34) is/are comprised onto said first surface (36) of the semiconductor body (20);

c) exposing through the thinfilm material a first opening (82) located at the one side of said thinfilm member (32, 34) and a second opening (82) located at the opposite side of said thinfilm member, with

d) the first opening (82) being bounded in part by one edge (110) of the thinfilm member (34) and the second opening (82) being bounded in part by the opposite edge (110C) of the same first thinfilm member (34) or a second thinfilm member (32);

e) both openings also being bounded in part by a boundary (111, 113) connected with its ends to an edge (110, 110C) of said first or second thinfilm member(s) (34, 32), but with its intermediate portion between said ends extending apart from said edges (110, 110C) of said thinfilm member(s) (34, 32);

f) selecting the configuration of said boundaries (111, 113) in relation to the crystalline structure of the semiconductor body (20) such that an anisotropic etch when placed on said openings (82) will

f1) undercut the thinfilm member(s) (32, 34),

f2) will not at said boundaries (111, 113) undercut the layer (28, 29) of said thinfilm material, but

f3) will form at said boundaries (111, 113) inwardly inclined wall surfaces (115) of said depression (30);

g) placing an anisotropic etch on said openings (82) to undercut the thinfilm member(s) (34, 32) and form the depression (30);

h) allow the etching process to continue until the semiconductor material of the semiconductor body (20) is removed under said thinfilm member(s) (34, 32).

2. The method of claim 1 used for fabricating a semiconductor device comprising two thinfilm members (34, 32) bridging said depression (30) parallel to each other, **characterized by** the steps of:

a) providing a third opening (82) between opposing edges (110A, 110B) of the first (34) and second (32) thinfilm members;

b) placing the anisotropic etch also on said third opening.

3. The method of claim 1 or 2, **characterized by** :

a) selecting a semiconductor body (20) comprising (100) silicon having a (100) plane, a (110) direction, and a first surface (36) substantially parallel to the (100) plane;

b) selecting the configuration of said thinfilm member(s) (34, 32) and of said boundaries (111, 113) such that

b1) the thinfilm member(s) (34, 32) is/are oriented at a non-zero angle to the (110) direction; and

b2) the boundaries (111, 113) include a first substantial boundary component (111) extending substantially in line with the (110) direction and a second substantial boundary component (113) extending substantially normal to the (110) direction.

4. The method of claim 3, **characterized by** selecting the non-zero angle at substantially 45˚.

5. A semiconductor sensing device comprising:

a) a semiconductor body (20) consisting of (100) silicon and having a (100) plane and a (110) direction, with a first surface (36) of the semiconductor body (20) being substantially parallel to the (100) plane;

b) a depression (30) etched into said first surface (36) of the semiconductor body (20);

c) at least one thinfilm sensor member (34, 32) bridging said depression between opposite edges thereof;

d) a thinfilm layer (28, 29) deposited on said first surface (36) of the semiconductor body (20);

e) openings (82) extending through said thinfilm layer (28, 29) at both sides of said sensor member(s) (34, 32) into said depression (30) with

f) a first boundary component (111) of said opening (82) extending substantially in line with the (110) direction,

g) a second boundary component (113) of said opening (82) extending substantially normal to the (110) direction, and

h) a third boundary component (110, 110C) of said opening (82) extending in parallel to said sensor member(s) (34, 32).

6. A semiconductor device according to claim 5, **characterized in that** the second boundary component (111) extends under about 45° with respect to the (110) direction.

7. A semiconductor device according to claim 5 or 6, including at least two thinfilm sensor members (34, 32) extending in parallel across the depression (30), **characterized in that** a third opening (82) is provided between opposing edges (110B, 110A) of neighboring sensor members (32, 34).

## Revendications

1. Procédé de fabrication d'un dispositif semi-conducteur comprenant un corps semi-conducteur (20), un renfoncement (30) gravé dans une première surface (36) dudit corps semi-conducteur et au moins un élément de film mince (32, 34) reliant ledit renfoncement entre des bords opposés de celle-ci, comprenant les étapes de :

   a) choisir un corps semi-conducteur (20) ayant une orientation prédéterminée par rapport à une structure cristalline dans le corps semi-conducteur ;

   b) appliquer une couche (28, 29) de matériau de film mince dont l'(les) élément(s) de film mince (32, 34) est(sont) disposé(s) sur ladite première surface (36) du corps semi-conducteur (20) ;

   c) découvrir à travers le matériau de film mince une première ouverture (82) située d'un coté dudit élément de film mince (32, 34), et une deuxième ouverture (82) située sur le coté opposé dudit élément de film mince ;

   d) la première ouverture (82) étant limitée en partie par un bord (110) de l'élément de film mince (34) et la seconde ouverture (82) étant limitée en partie par le bord opposé (110C) du meme premier élément de film mince (34) ou un second élément de film mince (32) ;

   e) les deux ouvertures étant également limitées en partie par une frontière (111, 113) reliée par ses extrémités à un bord (110, 110c) dudit premier ou second élément(s) de film mince (34, 32), mais sa partie intermédiaire entre lesdites extrémités s'étendant de part et d'autre desdits bords (110, 110c) dudit(desdits) élément(s) de film mince (34 32) ;

   f) choisir la configuration desdites frontières (111, 113) en fonction de la structure cristalline du corps semi-conducteur (20), de telle façon qu'une gravure anisotrope, quand elle est placée sur lesdites ouvertures (82),

   f1) creuser l'élément de film mince (32, 34),

   f2) ne pas creuser, auxdites frontières (111, 113) la couche (28, 29) dudit matériau de film mince, mais

   f3) former auxdites frontières (111, 113) des parois inclinées (115) vers l'intérieur dudit renfoncement (30) ;

   g) disposer une gravure anisotrope sur lesdites ouvertures (82) pour creuser l'(les) élément(s) de film mince (34, 32) et pour former le renfoncement (30) ;

   h) permettre au procédé de gravure de se poursuivre jusqu'à ce que le matériau semi-conducteur du corps semi-conducteur (20) soit enlevé sous le(s)dit(s) élément(s) de film mince (34, 32).

2. Le procédé de la revendication 1 utilisé pour la fabrication d'un dispositif semi-conducteur comprenant deux éléments de film mince (34, 32) reliant ledit renfoncement (30) parallèles l'un l'autre, caractérisé par les étapes de :

   a) prévoir une troisième ouverture (82) entre des bords opposés (110A, 110B) du premier (34) et du second (32) éléments de film mince ;

   b) placer la gravure anisotrope également sur ladite troisième ouverture.

3. Le procédé de la revendication 1 ou 2 caractérisé par :

   a) le choix d'un corps semi-conducteur (20) comprenant du silicium (100) ayant un plan (100), une direction (110) et une première surface (36) sensiblement parallèle au plan (100) ;

   b) le choix de la configuration dudit(desdits) élément(s) de film mince (34, 32) et desdites frontières (111, 113) de telle façon que

   b1) l'(les) élément(s) de film mince (34, 32) soit (soient) orienté(s) selon un angle différent de zéro par rapport à la direction (110) ; et

   b2) les frontières (111, 113) comprennent un premier composant de frontière substantiel (111) étant sensiblement aligné avec la direction (110) et un second composant de frontière substantiel (113) s'étendant sensiblement perpendiculairement à la direction (110).

4. Le procédé de la revendication 3, caractérisé par le choix de l'angle qui diffère de zéro à sensiblement 45°.

5. Dispositif de détection à semi-conducteur comprenant :

a) un corps semi-conducteur (20) constitué de silicium (100) et ayant un plan (100) et une direction (110), une première surface (36) du corps semi-conducteur (20) étant sensiblement parallèle au plan (100) ;

b) un renfoncement (30) gravé à l'intérieur de ladite première surface (36) du corps semi-conducteur (20) ;

c) au moins un élément détecteur en film mince (34, 32) reliant ledit renfoncement entre des bords opposés de celle-ci ;

d) une couche de film mince (28, 29) déposée sur ladite première surface (36) du corps semi-conducteur (20) ;

e) des ouvertures (82) s'étendant au travers de ladite couche de film mince (28, 29) des deux côtés dudit (desdits) élément(s) détecteur(s) (34, 32) dans ledit renfoncement (30) avec ,

f) un premier composant de frontière (111) de ladite ouverture (82) étant sensiblement aligné selon la direction (110),

g) un deuxième composant de frontière (113) de ladite ouverture (82) s'étendant sensiblement perpendiculairement à la direction (110), et

h) un troisième composant de frontière (110, 110C) de ladite ouverture (82) s'étendant parallèlement auxdits éléments détecteurs (34, 32).

6. Dispositif semi-conducteur selon la revendication 5, caractérisé en ce que le deuxième composant de frontière (111) s'étend selon 45° environ par rapport à la direction (110).

7. Dispositif semi-conducteur selon la revendication 5 ou 6, comprenant au moins deux éléments détecteurs en film mince (34, 32) s'étendant en parallèle transversalement au renfoncement (30), caractérisé en ce qu'une troisième ouverture (82) est prévue entre des bords opposés (110B, 110A) d'éléments détecteurs voisins (32, 34).

**Patentansprüche**

1. Verfahren zum Herstellen einer Halbleitervorrichtung mit einem Halbleiter-Grundkörper (20), einer in eine erste Oberfläche (36) des Grundkörpers geätzten Vertiefung (30) sowie wenigstens einem die Vertiefung zwischen gegenüberliegenden Kanten derselben überbrückenden Dünnfilmbauteil (32, 34), mit folgenden Schritten:

a) Auswahl eines Halbleiterkörpers (20) mit einer vorgegebenen Orientierung bezogen auf eine Kristallstruktur des Halbleiterkörpers;

b) Aufbringen einer Schicht (28, 29) von das Dünnfilmbauteil (32, 34) bildenden Dünnfilmmaterials auf die erste Oberfläche (36) des Halbleiterkörpers (20);

c) Belichten einer ersten Öffnung (82) auf der einen Seite des Dünnfilmbauteils sowie einer zweiten Öffnung (82) auf der gegenüberliegenden Seite des Dünnfilmbauteils jeweils durch das Dünnfilmmaterial; wobei

d) die erste Öffnung (82) teilweise durch eine Kante (110) des Dünnfilmbauteils (34) und die zweite Öffnung (82) teilweise durch die gegenüberliegende Kante (110C) des gleichen ersten (34) oder eines zweiten Dünnfilmbauteils (32) begrenzt wird;

e) beide Öffnungen ferner teilweise durch mit ihren Enden an einer Kante (110, 110C) des ersten oder zweiten Dünnfilmbauteils (34, 32) angrenzenden Grenzlinie (111, 113) begrenzt werden, die jedoch mit ihrem Zwischenteil zwischen den Enden von jenen Kanten (110, 110C) des Dünnfilmbauteils (34, 32) entfernt liegt;

f) Auswahl der Konfiguration jener Grenzen (111, 113) in Bezug auf die Kristallstruktur des Halbleiterkörpers (20) derart, daß ein auf die Öffnungen (82) aufgebrachtes anisotropes Ätzmittel

f1) das/die Dünnfilmbauteil(e) (32, 34) hinterschneidet;

f2) an den genannten Grenzlinien (111, 113) die Schicht (28, 29) des Dünnfilmmaterials nicht hinterschneidet, aber

f3) an jenen Grenzlinien (111, 113) nach innen geneigte Wandflächen (115) der Vertiefung (30) bildet;

g) Aufbringen eines anisotropen Ätzmittels auf die genannten Öffnungen (82), um das/die Dünnfilmbauteile (34, 32) zu hinterschneiden und die Vertiefung (30) zu bilden;

h) Fortsetzung des Ätzvorgangs, solange bis unter dem/den Dünnfilmbauteilen (34, 32) das Halbleitermaterial des Halbleiterkörpers (20) entfernt ist.

2. Verfahren nach Anspruch 1 zur Herstellung einer Halbleitervorrichtung mit zwei Dünnfilmbauteilen (34, 32), welche die Vertiefung (30) parallel zueinander überbrücken, **gekennzeichnet durch** die Schritte:

a) Vorsehen einer dritten Öffnung (82) zwischen gegenüberliegenden Kanten (110A, 110B) des ersten (34) und des zweiten (32) Dünnfilmbauteils;

b) Aufbringen eines anisotropen Ätzmittels auch auf jene dritte Öffnung.

3. Verfahren nach Anspruch 1 oder 2, **gekennzeichnet durch**

a) Auswahl eines Halbleiterkörpers (20) aus (100)-Silizium mit einer (100)-Ebene, einer (110)-Achse sowie einer zur (100)-Ebene praktisch parallelliegenden ersten Oberfläche (36);

b) Auswahl der Konfiguration des/der Dünnfilmbauteile (34, 32) und der Grenzlinien (111, 113) derart, daß

b1) das/die Dünnfilmbauteile bezogen auf die (110)-Achse in einem von Null abweichenden Winkel ausgerichtet sind;

b2) die Grenzlinien (111, 113) eine sich in Richtung der (110)-Achse erstreckende erste wesentliche Grenzlinienkomponente (111) sowie eine sich im wesentlichen rechtwinkelig zur (110)-Achse erstreckende zweite wesentliche Grenzlinienkomponente (113) aufweisen.

4. Verfahren nach Anspruch 3, **gekennzeichnet durch** die Auswahl des von Null abweichenden Winkels bei praktisch 45°.

5. Halbleiter-Sensorvorrichtung mit

a) einem Halbleiterkörper (20) aus (100)-Silizium mit einer (100)-Ebene und einer (110)-Achse, wobei eine erste Oberfläche (36) des Halbleiterkörpers (20) sich praktisch parallel zur (100)-Ebene erstreckt;

b) einer in die erste Oberfläche (36) des Halbleiterkörpers (20) geätzten Vertiefung (30);

c) wenigstens einem die Vertiefung zwischen gegenüberliegenden Kanten derselben überbrückenden Dünnfilm-Sensorbauteil (34, 32);

d) einem auf der ersten Oberfläche (36) des Halbleiterkörpers (20) aufgebrachten Dünnfilmschicht (28, 29);

e) Öffnungen (82), die sich zu beiden Seiten des Sensorbauteils/der Sensorbauteile (34, 32) durch die Dünnfilmschicht (28, 29) hindurch in die Vertiefung (30) erstrecken;

f) einer sich praktisch parallel zur (110)-Achse erstreckenden ersten Randlinienkomponente (111) der Öffnung (82);

g) einer sich im wesentlichen rechtwinkelig zur (110)-Achse erstreckenden zweiten Randlinienkomponente (113) der Öffnung (82); und

h) einer sich parallel zu dem Sensorbauteil, den Sensorbauteilen (34, 32) erstreckenden dritten Randlinienkomponente (110, 110C).

6. Halbleitervorrichtung nach Anspruch 5, **dadurch gekennzeichnet**, daß die zweite Randlinienkomponente (111) sich unter einem Winkel von etwa 45° gegenüber der (110)-Achse erstreckt.

7. Halbleitervorrichtung nach Anspruch 5 oder 6 mit wenigstens zwei parallel zueinander die Vertiefung (30) überbrückenden Dünnfilm-Sensorbauelementen (34, 32), **dadurch gekennzeichnet**, daß zwischen gegenüberliegenden Kanten (110B, 110A) benachbarter Sensorbauelemente (32, 34) eine dritte Öffnung (82) vorgesehen ist.

*Fig. 1*

AIR FLOW

[110]

EP 0 169 519 B1

Fig. IA

Fig. IB

Fig. 2

Fig. 3

Fig. 4

Fig. 5

EP 0 169 519 B1

Fig. 6